Europäisches Patentamt

European Patent Office

Office européen des brevets

(11) Publication number: **0 029 987**
**B1**

(12) **EUROPEAN PATENT SPECIFICATION**

(45) Date of publication of patent specification: **16.04.86**

(21) Application number: **80107316.4**

(22) Date of filing: **24.11.80**

(51) Int. Cl.⁴: **H 01 L 21/82,** H 01 L 27/02, H 01 L 21/322 // H03K19/091

(54) Semiconductor device.

(30) Priority: **29.11.79 JP 153604/79**

(43) Date of publication of application:
**10.06.81 Bulletin 81/23**

(45) Publication of the grant of the patent:
**16.04.86 Bulletin 86/16**

(84) Designated Contracting States:
**DE FR GB NL**

(56) References cited:
**US-A-3 812 519**

**IEEE TRANSACTIONS ON CONSUMER ELECTRONICS, vol. CE-25, no. 4, August 1979, pages 642-646, New York (USA); K. KANZAKI et al.: "One chip digital FM/AM frequency and clock indicator using improved 12L technology".**

The file contains technical information submitted after the application was filed and not included in this specification

(73) Proprietor: **Kabushiki Kaisha Toshiba
72, Horikawa-cho Saiwai-ku
Kawasaki-shi Kanagawa-ken 210 (JP)**

(72) Inventor: **Sasaki, Yoshitaka
241-2, Sanmai-cho
Kanagawa-ku Yokohama-shi (JP)**
Inventor: **Ozawa, Osamu
6201-150, Hara Hino-machi
Konan-ku Yokohama-shi (JP)**

(74) Representative: **Henkel, Feiler, Hänzel & Partner
Möhlstrasse 37
D-8000 München 80 (DE)**

(56) References cited:
**IEEE TRANSACTIONS ON ELECTRON DEVICES, vol. ED-24, no. 10, October 1977, pages 1269-1270, New York (USA); J.C. PLUNKETT et al.: "Inverse current gain improvement of bipolar transistors by double-base diffusion".**

Courier Press, Leamington Spa, England.

## Description

The present invention relates to a semiconductor device and, more particularly, to a semiconductor device having a bipolar transistor with an improved current amplification factor and which operates upside down with respect to the conventional transistor.

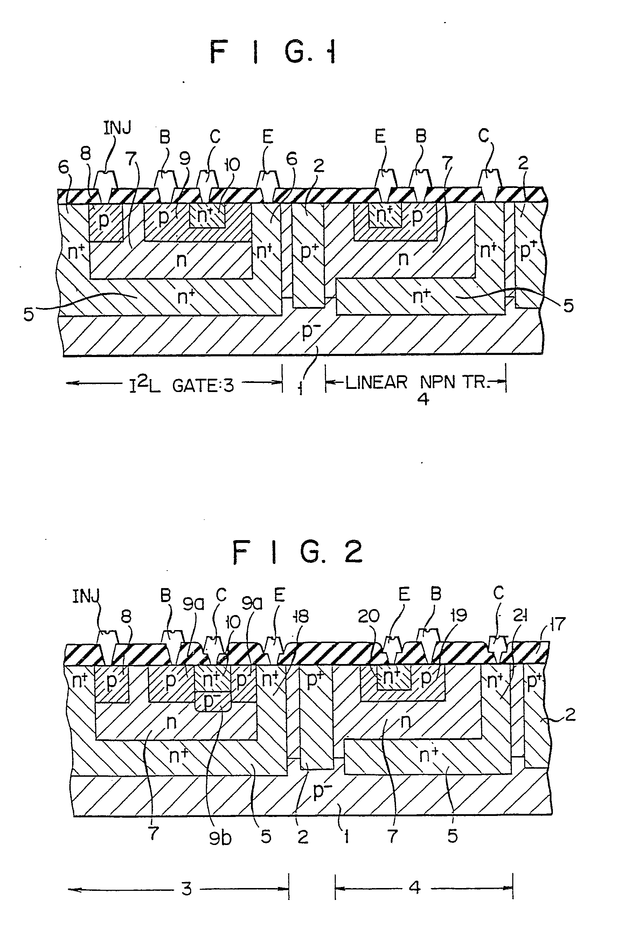

An integrated injection logic ($I^2L$) circuit is known as an integrated circuit including a bipolar transistor which operates upside down. Part of the integrated circuit of this type is illustrated in cross section in Fig. 1 and is disclosed in IEEE, J, of Solid-State circuits, SC-9, PP, 206 to 283, 1971. In Fig. 1, an $I^2L$ gate 3 and a linear npn transistor 4 are formed on a p-type semiconductor substrate 1, with a $p^+$ isolation region 2 disposed therebetween. Only the $I^2L$ gate will be described for simplicity. On the p-type substrate 1 are formed an $n^+$-type buried region 5, an $n^+$-type collar region 6 and an n-type region 7. Within the n-type region 7 are formed a p-type injector region 8, a p-type base region 9, and an $n^+$-type collector region 10 formed within the p-type base region 9. In the figure, INJ, B, C and E represent injector, base, collector and emitter terminals, respectively. Those semiconductor regions 7, 9 and 10 cooperate to form a bipolar transistor as operates reversely. Here, "bipolar transistor which operates upside down" means a transistor of the type in which the base current flows into the collector and will often be referred to as a upside-down transistor. The $n^+$ collar region 6 prevents holes injected from the base region 9 from flowing laterally, thereby to increase a current amplification factor of an npn transistor of the reverse-operation type. To prevent the lateral injection of the holes, it is more desirable that the impurity concentration of the $n^+$ collar region 6 is higher. Further, it is necessary that the region 6 is disposed closest to the base region 9. Conventionally, the collar region 6 was formed in a manner that phosphorus is diffused at high concentration from the main surface of the semiproduct by using phosphorus oxychloride ($POCl_3$). When the concentration of phosphorus is excessively increased in the surface region of the collar region 6, a number of lattice defects are produced in the surface region, and the lattice defects extend from the $n^+$ collar region 6 to the base region 9 of the upside-down npn transistor. As a result, the current amplification factor of the upside-down npn transistor decreases contrary to expectation. Therefore, the surface concentration of the $n^+$ collar region 6 can not be increased sufficiently and the current amplification factor of the upside-down npn transistor can not be increased.

Document "IEEE Transactions on Electron Devices", Vol. ED-24, No. 10, October 1977, pages 1269—1270, discloses a double-base diffused n-p-n transistor structure comprising a n-type semiconductor region, an upside-down bipolar transistor formed in said semiconductor region, said transistor including a $n^+$-type collector region with the surface thereof coincident with the main surface of said n-type semiconductor region, and a first $p^+$, p-type base region which contacts with the surfaces of said $n^+$-type collector region other than the upper surface of said $n^+$-collector region, a p-type injector region formed in said n-type semiconductor region, said p-type injector region having a surface coincident with the main surface of said n-type semiconductor region and a side surface facing said $p^+$, p-type base region with part of said n-type semiconductor region intervening there between, and a $n^+$-type collar region which is deeper than said $p^+$, p-type base region, in contact with said $p^+$, p-base region and said p-type injector region, and extending opposite to the main surface of said n-type semiconductor region.

Furthermore, document US—A—38 12 519 discloses a silicon semiconductor device in which a dislocation produced in an emitter region is compensated by highly doping phosphorus and arsenic simultaneously in this emitter region.

Finally, document "IEEE Transactions on Consumer Electronics", Vol. CE-25, no. 4, August 1979, pages 624—646, discloses a double-base $I^2L$-structure in which a $n^+$-type collar region is formed adjacent to a p-type base region and a p-type injector region without being in contact with these both p-type regions.

It is an object of the present invention to provide a semiconductor device including the upside-down bipolar transistor of which the reverse-directional current amplification factor is remarkably increased by completely removing the lattice defects in the $n^+$ collar region.

The semiconductor device according to the present invention comprises a semiconductor region of a second conductivity type, an upside-down bipolar transistor formed in said semiconductor region of said second conductivity type, said transistor including a second conductivity type collector region with the surface thereof coincident with the main surface of said second conductivity type semiconductor region and a first conductivity type base region which contacts with the surfaces of said collector region other than the upper surface of said collector region, a first conductivity type injector region formed in said second conductivity type semiconductor region, said injector region having a surface coincident with a main surface of said second conductivity type semiconductor region and a side surface facing said base region with part of said second conductivity type semiconductor region intervening therebetween, and a second conductivity type collar region which is deeper than said base region, in contact with or close to said base region and said injector region, and extending opposite to the main surface of said second conductivity type semiconductor region, and is characterized in that said collar region comprises high concentration of diffused phosphorus and arsenic.

This invention can be more fully understood from the following detailed description when taken in conjunction with the accompanying drawings, in which:

Fig. 1 shows a cross sectional view of a conventional semiconductor device including an $I^2L$ gate and an npn transistor as operates normally;

Fig. 2 shows a cross sectional view of an embodiment of a semiconductor device including an $I^2L$ gate and an npn linear transistor as operates normally according to the present invention;

Figs. 3A to 3F show a sequence of steps for manufacturing the semiconductor device shown in Fig. 2;

Figs. 4A and 4B show a manufacturing process for manufacturing another embodiment of the semiconductor device according to the invention;

Fig. 5A shows a photograph for showing lattice defects occurring in the $I^2L$ gate to which the conventional technique is applied in its fabrication;

Fig. 5B shows a photograph for showing lattice defects occurring in the $I^2L$ gate to which the present invention is applied in its fabrication; and

Fig. 6 shows characteristic curves of the current amplification factor ($\beta_{up}$) of the $I^2L$ gate with respect to the collector current, in which a curve 35 represents the characteristic when the present invention is used and a curve 36 represents the characteristic when the prior art is used.

Reference is made to Fig. 2 illustrating in cross section an embodiment of the semiconductor device including the $I^2L$ gate 3 and the npn linear transistor 4, which are formed on the p-type substrate 1, like Fig. 1. In Fig. 2, like reference numerals are used for designating like portions in Fig. 1, for simplicity. The $I^2L$ gate 3 includes the $n^+$ region 5, the injector region 8 formed in the n-type region 7 enclosed by the $n^+$ region 5 and $n^+$ collar region 18, an external base region 9a, an internal base region 9b, and the $n^+$ collector region 10 enclosed by the external base region 9a and the internal base region 9b. Those regions 5, 18, 7, 9a, 9b and 10 cooperates to form the upside-down bipolar transistor. The npn linear transistor 4 is electrically separated from $I^2L$ gate 3 by the $p^+$ isolation region 2, and is comprised of the $n^+$ region 5, an $n^+$ high concentration collector region 21, the n-type region 7, a p-type base region 19, and an emitter region 20 enclosed by the base region 19. The regions, 8, 9a, 10 and 18 are connected to its related circuit by electrodes INT, B, C and E. The regions 20, 19 and 21 are connected to its related circuit by the electrodes E, B and C. The $n^+$ collar region 18 of the $I^2L$ gate extends to the $n^+$ region 5 in contact with or close to the base region 9a. The feature of the present invention resides in that the collar region 18 is formed by diffusing phosphorus and arsenic at high concentration. In the present embodiment, the $n^+$ high concentration collector region 21 of the npn linear transistor 4 is also formed in the same manner. Reference numeral 17 designates an insulating layer.

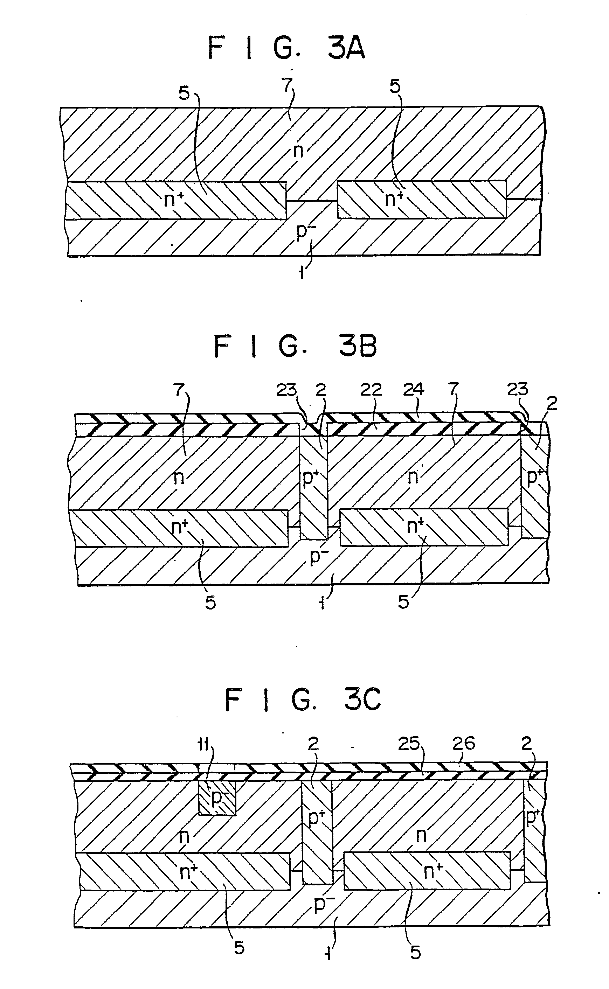

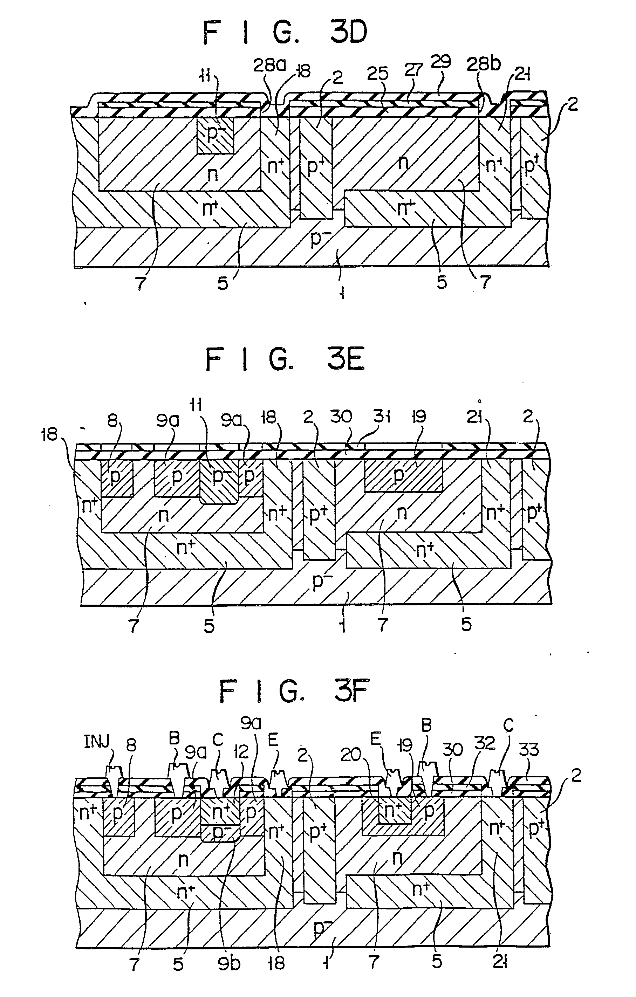

An example of the manufacturing method of the semiconductor device shown in Fig. 2 will be described referring to Figs. 3A to 3F. Although the fan-out of the $I^2L$ gate 3 of the device shown in Fig. 2 is one, two or more fan outs, npn linear transistors, resistors and capacitors and the like may be formed on the same chip. As shown in Fig. 3A, impurity material such as Sb, As and P is diffused from the main surface of the P type substrate 1 having a specific resistance of 10 $\Omega$.cm, of which the crystalline direction is <111> thereby to form the $n^+$ buried region 5 and then the n-type epitaxial region 7. As a matter of course, there arises no problem when the crystalline direction of the main surface of the semiconductor substrate 1 is <100>. When the breakdown voltage between the emitter and the collector of the linear transistor 4 is demanded to be 10 V or more, it is preferable to use the semiconductor substrate 1 with the (111) surface as the inversion voltage of a field region can be raised. The specific resistance and the thickness of the n-type epitaxial region 7 are determined by considering the breakdown voltage necessary for the linear transistor 4 coexisting with the $I^2L$ gate. Normally, those are selected to be 0.5 $\Omega$.cm to 2 $\Omega$.cm for the specific resistance and 5 $\mu$m to 20 $\mu$m for the thickness. Then, as shown in Fig. 3B, a thermal oxidation layer 22 ($SiO_2$ layer) is formed on the surface of the epitaxial region 7, holes 23 are formed at the locations corresponding to regions to be $p^+$ isolation regions 2, an insulating layer 24 containing boron is formed on the oxidation layer 22, and the $p^+$ isolation regions 2 are formed by diffusing boron. Boron silicate glass (BSG) containing boron at high concentration is generally used for the insulating layer 24. After forming the isolation regions 2, the entire thermal oxidation layer 22 and the BSG layer 24 are removed and the thermal oxidation layer ($SiO_2$ layer) 25 is again formed with the thickness from about 100 nm to 300 nm, as shown in Fig. 3C. Further, a resist pattern 26 is formed on the layer 25. An intrinsic base region 11 is formed by injecting boron ions into an intrinsic base region (the region for forming the internal base region 9b shown in Fig. 2) of the $I^2L$ gate 3, by using the resist pattern as a mask. At this time, if necessary, boron is also injected into another region to form a high resistor, at the dosage of $5 \times 10^{12}$ cm$^{-2}$ to $3 \times 10^{13}$ cm$^{-2}$. The acceleration voltage of the injecting ions depends on the thickness of the thermal oxidation layer 25, usually 50 keV to 200 keV. The depth of the intrinsic base region 11 is selected to be approximately 2.5 to 4 $\mu$m. Then, the resist pattern 26 is removed and a silicon dioxide layer 27 is formed, as shown in Fig. 3D, by a chemical vapor deposition process (CVD) using a chemical reaction of $SiH_4$ and $O_2$. At the locations where the collar region 18 and the high concentration collector region 21 are formed, holes 28a and 28b are formed in the thermal oxidation layer 25 and the CVD silicon dioxide layer 27. On the CVD layer 27 formed another silicon dioxide layer 29 [referred to as a (p+As) layer] containing phosphorus and arsenic. The (P+As) layer may be formed by mixing a mixed gas containing $PH_3$ and $AsH_3$ at the flow rate ratio of 4:1, into the gas containing $SiH_4$ and $O_2$ when they are thermally decomposed. The $n^+$ collar region 18 and the high concentration collector region 21 may be formed by diffusing P and As at about 1100°C by using the (P+As) layer as a diffusion source. The depth of the $n^+$ collar region 18 must be deeper than the depth of the intrinsic base region 11. As well known, the diffusion coefficient phosphorus is larger than that of arsenic. Therefore, the $n^+$ collar region 18 contains the phosphorus diffused deeply from the surface thereof and arsenic diffused shallowly from the surface. In this way, by simultaneously diffusing phosphorus and arsenic, the lattice defects (dislocation and the like) may be minimized which occurs in the collar region 18. Individual diffusion of phosphorus and arsenic may also effect the restriction of the lattice defect occurrence. A preferable ratio of arsenic to phosphorus ranges 3% to 40% in the number of atoms. In the experiment conducted, when the surface impurity concentration of the $n^+$ collar region 18 was set to $5 \times 10^{20}$ $cm^{-3}$ or more, the number of the lattice defects was $10^3$ $cm^{-2}$. Such number of lattice defects of $10^3$ $cm^{-2}$ were negligible in practical use. When only phosphorus was diffused by using phosphorus oxychloride $POCl_3$, as described above, the number of the lattice defects (dislocation density) in the surface of the collar region 18 was $10^5$ $cm^{-2}$. From the experimental results, it will be seen that the present invention may improve the lattice defects density of the $n^+$ collar region 18 by two or more orders when compared to the conventional method. When the concurrent diffusion of phosphorus and arsenic is applied to a region to be a high concentration $n^+$ collector region 21 of the linear transistor 4, as shown in Fig. 3D, the saturation voltage $V_{CE(SAT)}$ of the npn transistor 4 may be decreased. In case where the silicon substrate is used, the dislocation is most likely to occur in the crystalline direction of $<110>$ in the equivalent surfaces of (111). When only phosphorus is diffused into a region to be the $n^+$ collar region 18 and a region to be the high concentration collector region 21 by the conventional process, a number of the dislocation takes place in those regions. In this case, the dislocation extends into the equivalent surfaces of (111) in the peripheral semiconductor region. The rate of the extension of the dislocation is specially accelerated near the surface of the semiconductor region.

If the low saturation voltage is not required for the linear npn transistor 4 in its operation, there is no need of the high concentration for the collector region 21. When a pnp transistor (not shown) is provided on the chip on which the $I^2L$ gate 3 is formed, it is very effective to diffuse at high concentration phosphorus and arsenic in the base region of the pnp transistor. Specially in the pnp transistor with a large current, the reduction of the base resistance is remarkably important and it is possible to prevent reduction of the current amplification factor in a large current range.

After the diffusion of phosphorus and arsenic is made into the region to be the $n^+$ collar region 18 and the region to be the collector region 21, the (P+As) layer 29, the CVD silicon dioxide layer 27, and the thermal oxidation layer 25 are removed. In the next step, a thermal silicon dioxide layer 30 is formed, as shown in Fig. 3E and a resist pattern 31 is further formed as an ion injection mask on the layer 30. Through the pattern 31, boron ion is injected into the external base region 9a of the $I^2L$ gate 3, the injector region 8, and the base region 19 of the npn transistor 4. The concentration of the boron in the base region 19 is selected higher than that of the boron in the intrinsic base region 11, for the purpose of decreasing the specific resistance of the base region 19. The dosage of boron to be injected is selected to be $1 \times 10^{14}$ $cm^{-2}$ and the acceleration voltage is selected to be 50 keV to 300 keV. The depth of the base region 19 is approximately 2 μm to 3.5 μm, slightly shallower than the intrinsic base region 11. Afterward, the resist pattern 31 is removed and a CVD silicon dioxide layer 32 is deposited on the thermal silicon dioxide layer 30, as shown in Fig. 3F. In the next step holes are provided through the thermal silicon dioxide layer 30 and the CVD silicon dioxide layer 32 at the portions corresponding to the collector region 12 of the $I^2L$ gate 3 and the emitter region 20 of the npn transistor 4, as shown in Fig. 3F. A layer 33 like the (P+As) layer 33 used as the diffusion source when the $n^+$ collar region is formed on the CVD silicon dioxide layer 32 and phosphorus and arsenic are simultaneously diffused on the collector region 12 of the $I^2L$ gate 3 and the emitter region 20 of the linear npn transistor 4. Also in this case, phosphorus is diffused deeply while the arsenic is diffused shallowly into the near surface layer, so that no lattice defects take place in the collector region 12 and the emitter region 20. Also in this diffusion process, the ratio of arsenic to phosphorus in the number of atoms is selected to be 3 to 40%. After the diffusion process to the collector region 12 and the emitter region 20 is completed, the insulating layer 30, 32 and 33 are holed at the portions corresponding to the regions 8, 9a, 12 and 18 of the $I^2L$ gate 3 and the regions 20, 19 and 21 of the npn transistor 4 and electrodes for interconnections denoted as IN, B, C and E are formed. At this step, the fabrication process of the semiconductor device is completed.

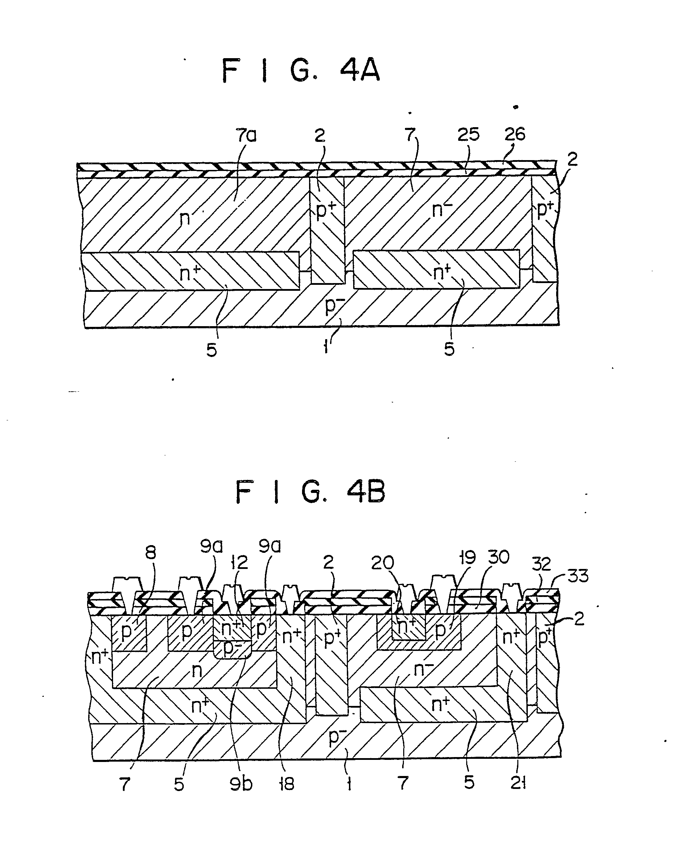

Figs. 4A and 4B illustrate a manufacturing process of another embodiment of the present invention. In the present embodiment, an epitaxial layer 7 with a specific resistance of 2 Ω.cm to 10 Ω.cm is formed on a p-type substrate 1. by using the thermal diffusion process for forming the $p^+$ isolation region 2, phosphorus is deeply diffused into only one epitaxial layer of the epitaxial layers on which the $I^2L$ layer is formed thereby to form an *n* well region 7a. As a result, the impurity concentrations in the regions 5, 7a and 7 are decreased in this order. The specific resistance of the *n* well region 7a may be reduced to approximately 0.1 $\Omega$.cm. In this way, when the I²L gate is formed within the *n* well region 7a, the switching speed of the I²L gate is increased to be about two times that when no *n* well region 7a is provided. Following the step shown in Fig. 4A, the steps shown in Figs. 3C to 3D are performed to form the semiconductor device shown in Fig. 4B. In semiconductor device shown in Fig. 4B, the reverse gain $\beta_{up}$ of the reverse operation transistor was 30; an input frequency of a T-type flip-flop formed by the I²L gate was 3 MHz; the power delay time product of the I²L gate was 0.18 pJ (pico joule), the emitter-collector breakdown voltage ($V_{CEO}$) was 40 V or more. Those values can not be obtained by the conventional device.

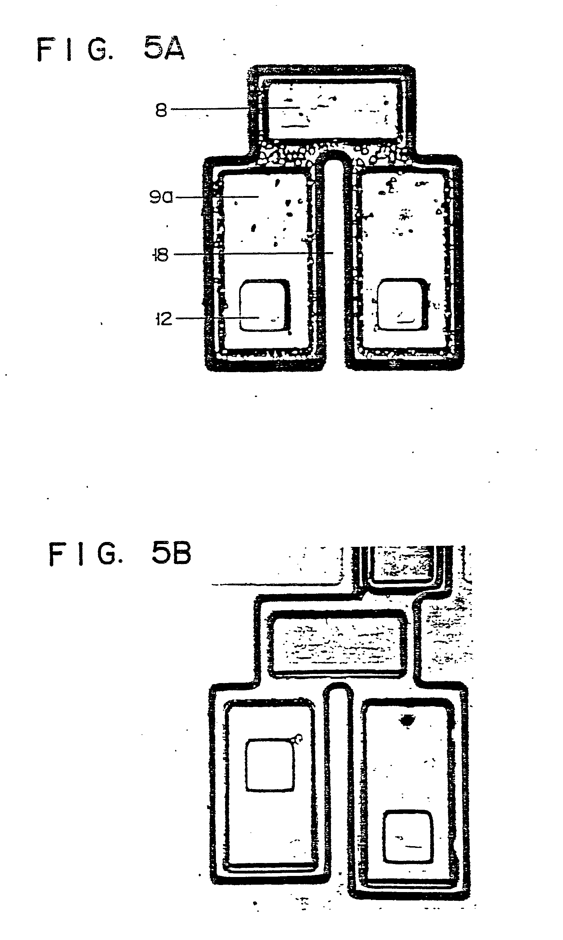

Fig. 5A is a microscopic photograph for illustrating lattice defects when the collar region 18 is formed by using phosphorus oxychloride POCl₃. Fig. 5B is a microscopic photograph for illustrating the lattice defects when the collar region 18 is formed by diffusing phosphorus and arsenic according to this invention in place of POCl₃. The semiconductor devices of the both are fabricated by the same process except for the diffusion process of the collar region 18. The chips of the I²L gates of the both were etched by the Wright etching solution. As observed in the photograph shown in Fig. 5A, triangular etch pits arising from the dislocation occuring in the collar region overflows into the active region other than the n⁺ collar region. Because of its high impurity concentration, the etching speed of the n⁺ collar region 18 is high. For this reason, the triangular etch pits were 10⁵ cm⁻² or more, although those are hardly observed. Such lattice defects provide the recombination centre of electrons and holes thereby to remarkably increase the base current of the upside-down transistor. Therefore, the current amplification factor of the reverse operation transistor is degraded. In the photograph shown in Fig. 5B, there were observed no etch pits due to the dislocation occurring in the collar region 18. When comparing the photographs in Figs. 5A and 5B, it is seen that the lattice defects occuring in the n⁺ collar region may be restrained when the n⁺ collar region is formed by diffusing phosphorus and arsenic. As described above, the lattice defects of the n⁺ collar region extends up to the active element region other than the I²L gate. Therefore, in order to increase the current amplification factor of the reverse operation transistor, it is essential to prevent the lattice defects from occurring in the n⁺ collar region.

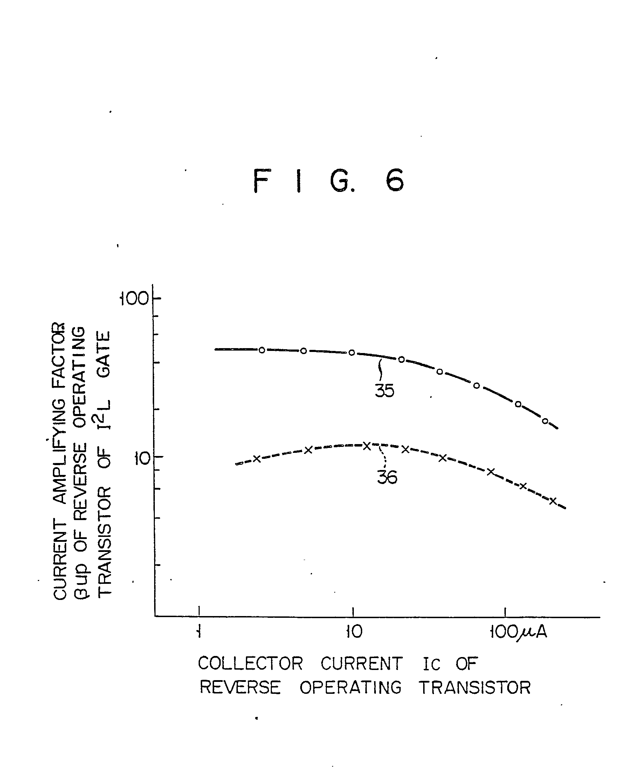

Turning now to Fig. 6, there is a graph representing a relation between a current amplification factor $\beta_{up}$ of the reverse operation transistor and the collector current Ic. In the graph, a curve 35 represents the $\beta_{up}$—Ic relation of the upside-down transistor fabricated by the present invention. A curve 36 represents that of the transistor formed by the conventional process. In the curve 35, tha maximum value of the $\beta_{up}$ is 45, which is about three times of the maximum $\beta_{up}$ in the curve 36. In the region where the Ic is small, the $\beta_{up}$ is decreased in the curve 36 while it is not decreased in the curve 35. It is apparent that the increase of the $\beta_{up}$ improves the operation speed of the I²L gate and the noise margin is increased.

The present invention which has been described by using the embodiment having the reverse operation npn transistor coexisting with the injector region, may of course be applied for the upside-down npn transistor not coexisting therewith. Also in the prior art linear npn transistor, the lattice defects in the high concentration collector region enters the base region, so that phosphorus is abnormally diffused into the emitter region of the linear transistor. Because of this, the breakdown voltage between the emitter and collector of the linear npn transistor was reduced. The present invention solves this problem by forming the high concentration region of the linear npn transistor by diffusing phosphorus and arsenic. As a result, the yield of products is improved about two times compared to the conventional technique.

## Claims

1. A semiconductor device comprising:
a semiconductor region (7) of a second conductivity type;
an upside-down bipolar transistor formed in said semiconductor region (7) of said second conductivity type, said transistor including a second conductivity type collector region (10; 12) with the surface thereof coincident with the main surface of said second conductivity type semiconductor region (7), and a first conductivity type base region (9a; 9b) which contacts with the surfaces of said collector region (10; 12) other than the upper surface of said collector region (10; 12);
a first conductivity type injector region (8) formed in said second conductivity type semiconductor region (7), said injector region (8) having a surface coincident with a main surface of said second conductivity type semiconductor region (7) and a side surface facing said base region (9a; 9b) with part of said second conductivity type semiconductor region (7) intervening therebetween; and
a second conductivity type collar region (18) which is deeper than said base region (9a; 9b), in contact with or close to said base region (9a) and said injector region (8), and extending opposite to the main surface of said second conductivity type semiconductor region (7);
characterized in that
said collar region (18) comprises high concentration of diffused phosphorus and arsenic.

2. The semiconductor device according to claim 1, characterized in that the crystalline direction of said main surface of said second conductivity type semiconductor region (7) is <111>-direction and the number of atoms of arsenic contained in said collar region (18) is 3% to 40% of that of phosphorus contained in said collar region (18).

**Revendications**

1. Dispositif à semiconducteur comprenant:

— une région semiconductrice (7) d'un second type de conductivité;

— un transistor bipolaire à l'envers formé dans la région semiconductrice (7) du second type de conductivité, le transistor incluant une région de collecteur de second type de conductivité (10; 12) dont la surface coïncide avec la surface principale de la région semiconductrice de second type de conductivité (7), et une région de base (9a; 9b) d'un premier type de conductivité qui est en contact avec les surfaces de la région de collecteur (10; 12) autres que la surface supérieure de la région de collecteur (10; 12);

— une région d'injecteur de premier type de conductivité (8) formée dans la région semiconductrice de second type de conductivité (7), la région d'injecteur (8) ayant une surface qui coïncide avec une surface principale de la région semiconductrice de second type de conductivité (7) et une surface latérale en regard de la région de base (9a; 9b), une partie de la région semiconductrice de second type de conductivité (7) étant interposée entre celles-ci; et

— une région en collier de second type de conductivité (18) qui est plus profonde que la région de base (9a; 9b), en contact avec ou proche de la région de base (9a) et de la région d'injecteur (8), et s'étendant à l'opposé de la surface principale de la région semiconductrice de second type de conductivité (7);

caractérisé en ce que la région en collier (18) comprend une concentration élevée en phosphore et en arsenic diffusés.

2. Dispositif à semiconducteur selon la revendication 1, caractérisé en ce que la direction cristalline de la surface principale de la région semiconductrice de second type de conductivité (7) est la direction <111> et en ce que le nombre d'atomes d'arsenic contenus dans la région en collier (18) est compris entre 3% et 40% de celui de phosphore contenu dans la région en collier (18).

**Patentansprüche**

1. Halbleitervorrichtung, umfassend
eine Halbleiterzone (7) eines zweiten Leitfähigkeitstyps,
einen in der Halbleiterzone (7) des zweiten Leitfähigkeitstyps ausgebildeten, umgedrehten oder kopfstehenden Bipolartransistor mit einer einen zweiten Leitfähigkeitstyp aufweisenden Kollektorzone (10; 12) deren Oberfläche mit der Hauptoberfläche der Halbleiterzone (7) des zweiten Leitfähigkeitstyps koinzidiert, und einer einen ersten Leitfähigkeitstyp aufweisenden Basiszone (9a; 9b), welche die von der Oberfläche der Kollektorzone (10; 12) verschiedenen Flächen der Kollektorzone (10; 12) kontaktiert,
eine in der Halbleiterzone (7) des zweiten Leitfähigkeitstyps ausgebildete, einen ersten Leitfähigkeitstyp aufweisende Injektorzone (8) mit einer mit einer Hauptfläche der Halbleiterzone (7) des zweiten Leitfähigkeitstyps koinzidierenden Fläche und einer Seitenfläche, welche der Basiszone (9a; 9b) mit teilweise daswischen liegender Halbleiterzone (7) des zweiten Leitfähigkeitstyps zugewandt ist, und
eine einen zweiten Leitfähigkeitstyp aufweisende Manschettenzone (18), die tiefer ist als die Basiszone (9a; 9b), mit der Basiszone (9a) und der Injektorzone (8) in Berührung steht oder dicht daran angeordnet ist und sich entgegengesetzt zur Hauptfläche der Halbleiterzone (7) des zweiten Leitfähigkeitstyps erstreckt, dadurch gekennzeichnet, daß die Manschettenzone (18) eine hohe Konzentration an eindiffundiertem Phosphor und Arsen aufweist.

2. Halbleitervorrichtung nach Anspruch 1, dadurch gekennzeichnet, daß die Kristallrichtung der Hauptfläche der Halbleiterzone (7) des zweiten Leitfähigkeitstyps die <111>-Richtung ist und die Zahl der in der Manschettenzone (18) enthaltenen Arsenatome 3—40% des (der) in der Manschettenzone (18) enthaltenen Phosphors (Phosphoratome) beträgt.

# F I G. 1

## F I G. 2

# F I G. 3A

# F I G. 3B

# F I G. 3C

# F I G. 3D

# F I G. 3E

# F I G. 3F

# F I G. 4A

# F I G. 4B

4

F I G. 5A

F I G. 5B

F I G. 6